# EUROPÄISCHE PATENTSCHRIFT

(11) **EP 2 165 584 B1**
(45) Veröffentlichungstag und Bekanntmachung des Hinweises auf die Patenterteilung: **20.04.2016**
(21) Anmeldenummer: 08750167.2
(22) Anmeldetag: 07.05.2008
(51) Int. Cl.: H05K 7/14, H05K 5/00

(54) **VERFAHREN UND VORRICHTUNG ZUM FESTLEGEN EINES EINE ELEKTRISCHE SCHALTUNG AUFWEISENDEN FLÄCHENSUBSTRATS IN EINER EINBAUPOSITION**
METHOD AND DEVICE FOR IMMOBILIZING A PLANAR SUBSTRATE IN A MOUNTING POSITION, SAID SUBSTRATE COMPRISING AN ELECTRIC CIRCUIT
PROCÉDÉ ET DISPOSITIF POUR CALER DANS UNE POSITION DE MONTAGE UN SUBSTRAT PLAT ÉQUIPÉ D'UN CIRCUIT ÉLECTRIQUE

(30) Priorität: 04.06.2007 DE 102007025957
(43) Veröffentlichungstag der Anmeldung: 24.03.2010
(73) Patentinhaber: Robert Bosch GmbH, 70442 Stuttgart (DE)
(72) Erfinder: GUYENOT, Michael, 71638 Ludwigsburg (DE); GEISSLER, Alexander, 07616 Buergel (DE)
(86) Internationale Anmeldenummer: PCT/EP2008/055653
(87) Internationale Veröffentlichungsnummer: WO 2008/148620

(56) Entgegenhaltungen:
- EP-A2- 0 689 374
- EP-A2- 1 581 037
- WO-A-01/87029
- WO-A-95/35015
- GB-A- 2 164 803
- US-A- 5 009 311

## Beschreibung

Die Erfindung betrifft ein Verfahren zum Festlegen eines eine elektrische Schaltung oder dergleichen aufweisenden Flächensubstrats in einer Einbauposition an einem Einbauelement, wobei ein Haltemittel das Flächensubstrat zur Festlegung beaufschlagt. Die Erfindung betrifft ferner eine Vorrichtung, insbesondere zur Durchführung dieses Verfahrens, mit mindestens einem eine elektrische Schaltung oder dergleichen aufweisenden Flächensubstrat, das in einer Einbauposition an einem Einbauelement festgelegt ist, wobei ein Haltemittel das Flächensubstrat zur Festlegung beaufschlagt.

### Stand der Technik

Eine elektrische Schaltung oder dergleichen aufweisende Flächensubstrate sind bekannt, beispielsweise werden diese als Leiterplatten/Platinen zur Verwirklichung elektronischer Schaltkreise ausgebildet. Solche Flächensubstrate sind zusammen mit der auf ihnen angeordneten Schaltung im Regelfall in bestimmten Einbaupositionen zu halten, beispielsweise in ein Baurahmen oder in Gehäusen, wobei insbesondere Letztere auch der Abschirmung der auf dem Flächensubstrat befindlichen Schaltung dient. Solche Flächensubstrate, insbesondere Leiterplatten, werden derzeit in Gehäusen auf verschiedenste Arten montiert. Im Regelfall geschieht dies durch Schrauben, Verstemmen, Verklipsen oder durch das Einklemmen zwischen Gehäuseteilen. Hieran ist nachteilig, dass diese aus dem Stand der Technik bekannten Befestigungsmethoden im Regelfall über relativ kleine Flächenabschnitte der Leiterplatte erfolgen, beispielsweise erfolgt eine Abstützung bei Verschraubungen über einen Schraubenkopf, der relativ zur Gesamtfläche der Leiterplatte eine kleine Auflagefläche aufweist. Hierdurch werden auf die Leiterplatte lokal relativ hohe Kräfte bewirkt, die zu sehr hohen Verspannungen führen können. Hierdurch wird die Leiterplatte einer mehr oder weniger ungleich verteilten, sehr starken mechanischen Belastung ausgesetzt, was sich nachteilig auf ihre Lebensdauer auswirken kann. Ferner müssen die Gehäuseformen zur Aufnahme von Leiterplatten in konventioneller Art und Weise relativ kompliziert ausgeformte Abstützungen aufweisen, die beispielsweise der Aufnahme von Schrauben dienen. Weiter ist erforderlich, dass die Leiterplatte für diese konventionellen Befestigungsmethoden innerhalb des Gehäuses insgesamt direkt zugänglich sein muss. Gerade bei großflächigen und/oder komplizierten Leiterplatten müssen die Gehäuse vielteilig ausgebildet werden. Dies führt zu erhöhten Kosten und erhöhtem Aufwand, insbesondere dann, wenn diese Gehäuse erhöhte Abdichtungsfunktionen aufweisen müssen, wie dies beispielsweise bei Anwendungen unter rauen Umgebungsbedingungen, etwa in Motorräumen von Kraftfahrzeugen, erforderlich ist.

Aus der Offenlegungsschrift GB 2 164 803 A ist eine Vorrichtung bekannt, bei welcher mehrere Flächensubstrate in ein Grundgehäuse einschiebbar sind. Dazu sind in dem Grundgehäuse Führungsschienen vorgesehen, denen jeweils ein sich über die jeweilige Führungsstrecke längs erstreckendes Federelement zugeordnet ist, welches bei erhöhten Temperaturen eine erhöhte Federkraft entwickelt und auf das jeweilige Flächensubstrat auswirkt. Bei fallender Temperatur verringert sich wiederum die jeweilige Federkraft, so dass bei niedrigen Temperaturen die Flächensubstrate stets leicht aus den Führungsschienen heraus oder in die Führungsschienen hereingeschoben werden können.

Weiterhin ist aus der Offenlegungsschrift EP 0 689 374 A2 ein Elektronikmodul bekannt, bei welchem ein Flächensubstrat ebenfalls mit Hilfe einer Führungsschiene in ein Grundgehäuse einschiebbar ist. Dabei ist das Flächensubstrat fest mit einem Gehäusedeckel verbunden, der das Grundgehäuse im eingeschobenen Zustand des Flächensubstrats verschließt. Zur Befestigung und Arretierung des Flächensubstrates und des Gehäusedeckels an dem Grundgehäuse ist eine Schraubverbindung vorgesehen, mittels welcher der Gehäusedeckel an dem Grundgehäuse befestigt wird.

Die Offenlegungsschrift EP1581037 beschreibt die Möglichkeit, durch Vorsehen einer gleichen Harzmasse an unterschiedlichen Stellen eines Elektronikmodules zwei von einander unterschiedliche Funktionen - nämlich zum einen ein Fixieren einer Elektronikeinheit im Inneren eines Grundgehäuses und zum anderen ein Abdichten eines Gehäusedeckels gegen das Grundgehäuse - zu realisieren.

### Offenbarung der Erfindung

Aufgabe der Erfindung ist es, eine sichere, einfache und kostengünstige Fixierung von eine elektrische Schaltung aufweisenden Flächensubstraten in einem Einbauelement bereitzustellen, wobei die genannten Nachteile vermieden werden.

Hierzu wird ein Verfahren zum Festlegen eines eine elektrische Schaltung oder dergleichen aufweisenden Flächensubstrats in einer Einbauposition an einem Einbauelement mit den Merkmalen des Anspruchs 1 vorgeschlagen, wobei ein Haltemittel das Flächensubstrat zur Festlegung beaufschlagt. Hierbei ist vorgesehen, dass als Haltemittel ein durch Temperaturbeaufschlagung aktivierbares Ausdehnmittel verwendet wird. Das Haltemittel hat hierbei die Aufgabe, das Flächensubstrat zur Festlegung in seiner Einbauposition an dem Einbauelement mit einer Kraft zu beaufschlagen. Als Haltemittel wird ein Ausdehnmittel verwendet, das aktivierbar ist. Hiermit ist gemeint, dass nach Aufbringung eines bestimmten Impulses beziehungsweise nach Bewirkung einer Initialwirkung das Ausdehnmittel mit dem Ausdehnungsvorgang beginnt, nachdem es zunächst eine nicht ausgedehnte Lage inne hatte. Durch diese Aktivierung wird die Ausdehnung des Ausdehnmittels gewissermaßen gestartet beziehungsweise veranlasst. Durch das Ausdehnmittel lässt sich das Flächensubstrat über eine größere Fläche beziehungsweise einen größeren Abschnitt beaufschlagen, was zu einer gleichmäßigen Kräfteverteilung im Flächensubstrat führt und Punktbelastungen vermeidet.

In einer bevorzugten Ausführungsform wird das Flächensubstrat durch das Ausdehnmittel klemmend beaufschlagt. Hiermit ist gemeint, dass das Ausdehnmittel das Flächensubstrat einklemmt, wobei eine Klemmung beidseitig des Flächenssubstrates erfolgen kann, oder aber einseitig, insbesondere unter Abstützung an dem Einbauelement. Auf diese Weise werden Verschraubungen, Verklipsungen et cetera vermieden.

In einer Verfahrensausbildung erfolgt die Aktivierung des Ausdehnmittels auch durch Schwingungsbeaufschlagung oder Mediumbeaufschlagung, insbesondere mittels Gasen und/oder Flüssigkeiten. Das Ausdehnmittel ist zunächst in seiner nicht ausgedehnten Position und gewissermaßen inaktiv. Erst nach Beaufschlagung durch Temperatur und durch Schwingungen (beispielsweise Ultraschall) oder ein Medium, insbesondere durch Gase und/oder Flüssigkeiten, beginnt das Ausdehnmittel mit der Ausdehnung und entfaltet die gewünschte Wirkung. Die Wahl des Aktivierungsmittels hängt hierbei davon ab, welcher Art das Ausdehnmittel ist, beziehungsweise aus welcher Stoffgruppe das Ausdehnmittel gewählt wurde. Insbesondere ist es auch möglich, von mehreren alternativ oder kumulativ in Betracht kommenden Aktivierungsmitteln dasjenige zu wählen, das für die jeweilige Anwendung und das jeweils gewählte Ausdehnmittel die einfachste und/oder günstigste Handhabung ermöglicht.

In einer anderen Verfahrensausbildung ist vorgesehen, dass die Aktivierung des Ausdehnmittels auch durch Zeitablauf erfolgt. Beispielsweise ist es möglich, ein Ausdehnmittel zu verwenden, das nach Abschluss seines Herstellungsprozesses beziehungsweise nach vorangegangener, nicht mit der Festlegung des Substrats zusammenhängenden Aktivierung, nach einer bestimmten Zeit mit seiner Ausdehnung beginnt und/oder nach einer bestimmten Zeit eine bestimmte Ausdehnung erreicht hat. Hierbei ist es dann erforderlich, die zeitliche Komponente in geeigneter Weise zu überwachen und die entsprechend gealterten Ausdehnmittel zum richtigen Zeitpunkt einzusetzen.

In einer Verfahrensausbildung ist vorgesehen, dass als Ausdehnmittel ein chemisches, erhärtendes Mittel verwendet wird. Solche Mittel haben den Vorteil, dass sie leicht herstellbar sind und aufgrund ihrer chemischen Zusammensetzung die oben beschriebene Aktivierung in der gewünschten einfachen Weise zulassen. Dadurch, dass diese Mittel erhärten, fixieren sie das festgelegte Flächensubstrat in seiner Einbauposition zuverlässig, ohne von der nach Erhärtung eingenommenen Position wieder abzugehen. Insbesondere kann so ein auch unter Ruckeln und Kraftbeaufschlagung vibrationsarmes oder vibrationsfreies Festlegen des Flächensubstrats in seiner Einbauposition bewirkt werden. Die Kraftbeaufschlagung erfolgt großflächig unter Vermeidung von Punktbelastungen.

In der erfindungsgemäßen Verfahrensausbildung wird als Ausdehnmittel ein Schaum, insbesondere Epoxy-Schaum verwendet. Epoxy-Schaum ist aus dem Stand der Technik bekannt und leicht beherrschbar. Er lässt sich insbesondere in einer Zusammensetzung herstellen, die für die jeweilige Anwendung die gewünschten Eigenschaften aufweist. Überdies wirkt Epoxy-Schaum isolierend, so dass auf dem Flächensubstrat angeordnete Bauteile und/oder Leiterbahnen direkt mit dem Epoxy-Schaum in Berührung kommen können.

Weiter wird eine Vorrichtung mit den Merkmalen des Anspruchs 4 vorgeschlagen, insbesondere zur Durchführung des Verfahrens, wie vorstehend beschrieben, mit mindestens einem eine elektrische Schaltung oder dergleichen aufweisenden Flächensubstrat, das in einer Einbauposition an einem Einbauelement festgelegt ist, wobei ein Haltemittel das Flächensubstrat zur Festlegung beaufschlagt. Hierbei ist vorgesehen, dass das Haltemittel als aktivierbares Ausdehnmittel ausgebildet ist. Wie bereits vorstehend zum Verfahren beschrieben, ist das Haltemittel ein aktivierbares Ausdehnmittel, also ein solches, das sich nach einer Aktivierung in seiner Geometrie verändert, insbesondere vergrößert. Erfindungsgemäß wird ein Schaum als Ausdehnmittel verwendet. Nach Einwirkung einer Initialwirkung, die gewissermaßen als Startsignal wirkt, verändert sich das Ausdehnmittel raumgreifend. Durch diese Vergrößerung des Ausdehnmittels wird eine Kraftbeaufschlagung des Flächensubstrats erreicht, wobei das Ausdehnmittel hierdurch das Flächensubstrat festlegt.

Erfindungsgemäß ist das Einbauelement als Einbaugehäuse ausgebildet. Prinzipiell kommen sämtliche denkbaren, aus dem Stand der Technik bekannten Einbauelemente in Betracht, insbesondere also solche, die einseitig oder mehrseitig offen sind oder das Flächenelement auch nur bereichsbeziehungsweise abschnittsweise umfassen, umgreifen oder anderweitig halten. Insbesondere sind beispielsweise die bekannten 19-Zoll-Einschubrahmen oder ähnliche Einbauelemente denkbar. Bevorzugt aber sind die Einbauelemente als Einbaugehäuse ausgebildet, also als solche Gehäuse, in die das Flächensubstrat eingebracht wird. Das Flächensubstrat wird demzufolge in seiner Einbauposition, in der es festgelegt werden soll, von dem Gehäuse zumindest überwiegend umgriffen.

In einer bevorzugten Ausführungsform weist das Einbaugehäuse eine Abstützung für mindestens eine Fläche des Flächensubstrats auf, wobei das Haltemittel die gegenüberliegende Fläche des Flächensubstrats klemmend beaufschlagt. Das Flächensubstrat wird folglich bereichsweise über eine Fläche abgestützt, wobei diese Abstützung innenseitig an dem Einbaugehäuse ausgebildet oder angeordnet ist. Das Flächensubstrat liegt also gewissermaßen über die Fläche an der Abstützung auf oder an. Die dieser Fläche gegenüberliegende Fläche des Flächensubstrats (also die andere Seite des Flächensubstrats) wird durch das Haltemittel klemmend beaufschlagt. Durch diese klemmende Beaufschlagung ergibt sich die Festlegung des Flächensubstrats über eine Klemmwirkung, die zwischen der Abstützung einerseits, nämlich an der einen Fläche des Flächensubstrats, und dem Haltemittel an der anderen, dieser gegenüberliegenden Fläche des Flächensubstrats andererseits ergibt, wobei sich das Haltemittel seinerseits zwischen dem Flächensubstrat und einem Teil des Einbaugehäuses, das dem Flächensubstrat gegenüberliegt, abstützt. Das Flächensubstrat wird folglich in diesem Bereich ausschließlich durch die Klemmwirkung gehalten, die über das Haltemittel und die Abstützung aufgebracht wird.

Erfindungsgemäß weist das Einbaugehäuse ein Grundgehäuse und einen Gehäusedeckel auf. Das Grundgehäuse ist hierbei als der Teil des Einbaugehäuses zu verstehen, in den das Flächensubstrat eingebracht wird, und das das Flächensubstrat umgreift. Beispielsweise ist hier eine Ausführungsform gemeint, die nur einseitig offen ist, wobei diese eine Seite durch den Gehäusedeckel verschlossen wird.

Erfindungsgemäß wird das Flächensubstrat an dem Gehäusedeckel befestigt und im Bereich des Grundgehäuses vom Haltemittel beaufschlagt. Das Haltemittel ist demzufolge im Bereich des Grundgehäuses angeordnet, das Flächensubstrat aber an dem Gehäusedeckel befestigt. Dies erlaubt es, das Flächensubstrat über die Handhabung des Gehäusedeckels auf einfache Weise in das Grundgehäuse einzubringen, beispielsweise einzuschieben, wobei die Beaufschlagung durch das Haltemittel im Bereich des Grundgehäuses erfolgt. Das Haltemittel ist demzufolge im Grundgehäuse angeordnet oder wird in dieses eingebracht, bevor das Flächensubstrat über die Handhabung des Gehäusedeckels ebenfalls in das Grundgehäuse eingebracht wird. Nach Einbringung des Flächensubstrats kann dann die Aktivierung des Haltemittels, nämlich des Ausdehnmittels, erfolgen, so dass die Klemmwirkung und damit die Festlegung des Flächensubstrats innerhalb des Grundgehäuses eintritt. Auf diese Weise wird auch der Deckel an dem Grundgehäuse gehalten (da dieser mit dem Flächensubstrat verbunden ist ) und dieses innerhalb des Grundgehäuses festgelegt ist). Bei geeigneter Ausgestaltung der Geometrie von Grundgehäuse und Gehäusedeckel wird der Deckel hierbei auch dicht gehalten.

In einer weiteren Ausführungsform ist vorgesehen, dass das Grundgehäuse eine Geometrie aufweist, bei der das Haltemittel in einem nicht oder nur schwer zugänglichen Bereich angeordnet ist. Insbesondere ist das dann der Fall, wenn das Grundgehäuse beispielsweise topfartig ausgebildet ist, wobei unter topfartig selbstverständlich nicht nur solche Ausführungsformen mit einem im Wesentlichen kreisförmigen Querschnitt verstanden werden, sondern auch solche mit einem recht- oder mehreckigen Querschnitt. Den topfartigen Ausführungsformen ist gemein, dass das Grundgehäuse in seiner Längserstreckung geschlossen ist, der Gehäusedeckel folglich an einer Schmalseite/Stirnseite angeordnet ist, nicht aber an einer Längsseite des Gehäuses. Der Gehäusedeckel ist damit zur Gesamtausdehnung des Grundgehäuses relativ klein, so dass das Flächensubstrat in die Tiefe des Gehäuses eingebracht werden muss. Hierbei ist häufig wünschenswert, dass insbesondere in den Fällen, in denen das Flächensubstrat mit dem Gehäusedeckel verbunden ist, an der dem Deckel gegenüberliegenden Seite (also in der Tiefe des Grundgehäuses, die nicht ohne Weiteres zugänglich ist) eine Festlegung des Flächensubstrats erfolgt, was aber mit den aus den Stand der Technik bekannten Methoden des Schraubens und Verklipsens nur schwer oder gar nicht erfolgen kann. Wird dort hingegen ein Haltemittel in Form eines Ausdehnungsmittels eingebracht, insbesondere so, dass auch eine Abstützung des Flächensubstrats in Gegenüberlage des Haltemittels vorliegt, auf die das Flächensubstrat bei der Einbringung aufgelegt werden kann, ergibt sich eine sehr gute Klemmung und Festlegung nach Aktivierung des Ausdehnmittels.

Weitere vorteilhafte Ausführungsformen ergeben sich aus den Unteransprüchen und aus Kombinationen derselben.

### Kurze Beschreibung der Zeichnungen

Die Erfindung wird nachfolgend anhand von Ausführungsbeispielen und Figuren näher erläutert.

Es zeigen
- Figur 1: ein aus Grundgehäuse und Gehäusedeckel gebildetes Einbaugehäuse mit einem eingebrachten Flächensubstrat vor Aktivierung des Haltemittels,
- Figur 2: dasselbe Gehäuse nach Aktivierung des Haltemittels und
- Figur 3: dasselbe Gehäuse, wobei das Haltemittel als Federelement aus Formgedächtnislegierungswerkstoff ausgebildet ist, und keine Ausführungsform der Erfindung darstellt.

### Ausführungsform(en) der Erfindung

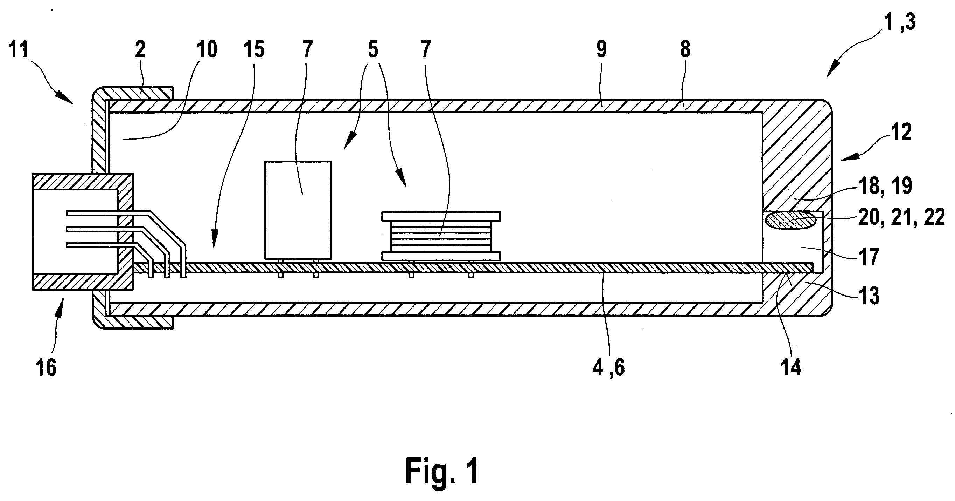

Figur 1 zeigt eine in einem Einbauelement 1, nämlich einem mit einem Gehäusedeckel 2 versehenen Einbaugehäuse 3 auf einem Flächensubstrat 4 angeordnete elektrische Schaltung 5. Die elektrische Schaltung 5 ist hierbei beispielsweise auf dem als Leiterplatte 6 ausgebildeten Flächensubstrat 4 in systematischer Anordnung von Bauelementen 7 verlötet. Das Einbaugehäuse 3 ist als topfförmiges Gehäuse 8 ausgebildet, also als ein solches, das ein Grundgehäuse 9 aufweist, dessen Gehäuseöffnung 10 an einer Schmalseite 11 angeordnet ist. Die Gehäuseöffnung 10 wird nach Einbringung der auf dem Flächensubstrat 4 angeordneten elektrischen Schaltung 5 mittels des Gehäusedeckels 2 verschlossen. An der der Gehäuseöffnung 10 gegenüberliegenden Gehäuseseite 12 weist das Einbaugehäuse 3 eine Abstützung 13 auf, auf der sich in Einbauposition das Flächensubstrat 4 mit einer Fläche 14 abstützt. Das Flächensubstrat 4 ist folglich in gewisser Weise auf die Abstützung 13 "aufgelegt". An der deckelseitigen Seite 15 des Flächensubstrats 4 ist das Flächensubstrat 4 mit dem Gehäusedeckel 2 beispielsweise über einen im Flächensubstrat 4 festgelöteten, den Gehäusedeckel 2 durchgreifenden Kontaktstecker 16 verbunden. Das Flächensubstrat 4 wird folglich bei Handhabung des Gehäusedeckels 2 ebenfalls der Handhabung unterworfen, da es über den Kontaktstecker 16 mit dem Gehäusedeckel 2 mechanisch verbunden ist und so über den Gehäusedeckel 2 bewegt werden kann. Dies ist insbesondere zur Einbringung des Flächensubstrats 4 in das topfförmige Gehäuse 8 sinnvoll, da der Gehäusedeckel 2 die einfache Handhabung des Flächensubstrats 4 erlaubt, insbesondere dessen Einführung in einen Klemmbereich 17, der zwischen der Abstützung 13 und einer dieser beabstandet gegenüberliegenden, innerhalb des Einbaugehäuses 3 angeordneten Gegenabstützung 18 gebildet wird. Die Gegenabstützung 18 dient hierbei als Haltemittelanlage 19, dadurch, dass an ihr ein Haltemittel 20 in Gegenüberlage zur Abstützung 13 abgebracht ist. Das Haltemittel 20 ist ein Ausdehnmittel 21, das in nicht ausgedehnter Form vorliegt. Insbesondere ist das Ausdehnmittel 21 ein Epoxy-Schaum 22. In der vorliegenden Darstellung ist das Flächensubstrat 4 in das Einbaugehäuse 3 eingebracht, wobei es auf der Abstützung 13 einerseits aufliegt und über den auf das Grundgehäuse 9 aufgestülpten Gehäusedeckel 2 und den den Gehäusedeckel 2 durchdringenden Kontaktstecker 16 andererseits gehalten wird. Das Haltemittel 20 ist hierbei noch nicht in Funktion.

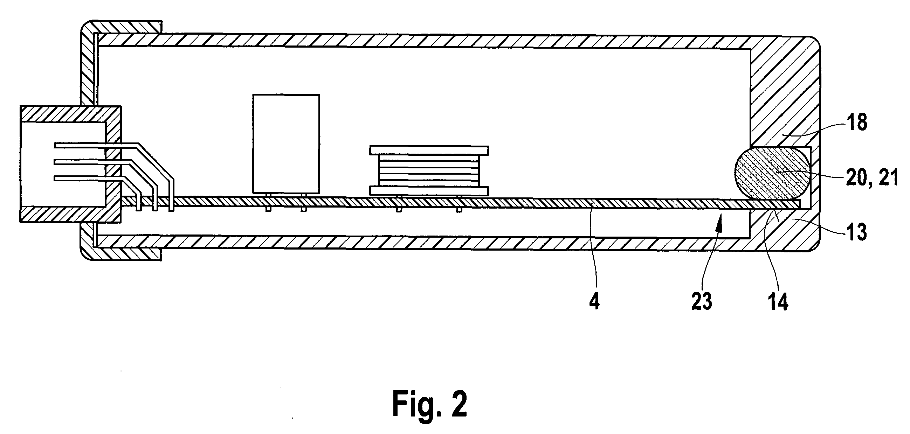

Figur 2 zeigt dieselbe Anordnung, wobei das Flächensubstrat 4 nunmehr an seinem dem Gehäusedeckel 2 gegenüberliegenden Ende 23 oberseitig von dem nun ausgedehnten Ausdehnmittel 21 als Haltemittel 20 beaufschlagt wird. Das Ausdehnmittel 21 stützt sich hierbei an der Gegenabstützung 18 einerseits und an dem Flächensubstrat 4 andererseits ab, wobei sich das Flächensubstrat 4 mit seiner unterseitigen, dem Ausdehnmittel 21 abgewandten Fläche 14 an der Abstützung 13 abstützt. Durch die Ausdehnung des Ausdehnmittels 21, nämlich des Haltemittels 20, wird somit eine Klemmwirkung hinsichtlich des Flächensubstrats 4 zwischen dem Haltemittel 20 und der Abstützung 13 bewirkt, die das Flächensubstrat 4 in der Einbauposition festlegt.

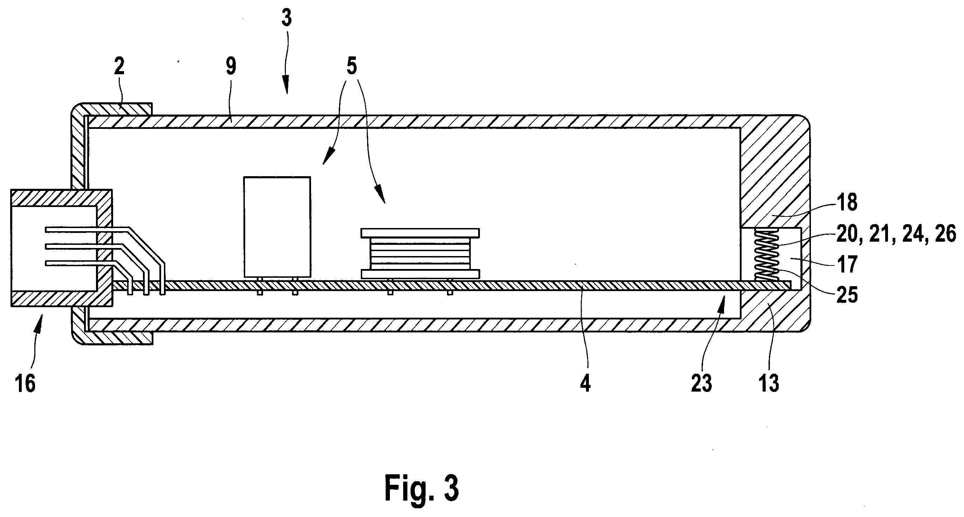

Figur 3 zeigt dieselbe Anordnung, so dass insoweit auf die Figuren 1 und 2 Bezug genommen werden kann. Diese Anordnung ist aber keine Ausführungsform der Erfindung. Als Haltemittel 20 beziehungsweise Ausdehnmittel 21 kommt jedoch hier ein Federelement 24 aus einer Formgedächtnislegierung 25 zum Einsatz. Das Federelement 24 bildet somit ein Mittel mit Formgedächtnis 26, das die vorstehend beschriebene Klemmwirkung zwischen Gegenabstützung 18 einerseits und dem sich auf der Abstützung 13 abstützenden Flächensubstrat 4 andererseits bewirkt. Das Flächensubstrat 4 wird demzufolge auf die vorstehend beschriebene Weise durch die Klemmwirkung des Mittels mit Formgedächtnis 26, das im Klemmbereich 17 angeordnet ist einerseits und durch seine mechanische Verbindung mit dem dem Gehäusedeckel 2 durchdringenden, mit diesem verbundenen Kontaktstecker 16 andererseits bewirkt, wobei der Gehäusedeckel 2 auf das Grundgehäuse 9 aufgesteckt ist. Gerade durch die mechanische Fixierung des Flächensubstrats 4 über den Kontaktstecker 16 am Gehäusedeckel 2 lässt sich bei Einsatz des Mittels mit Formgedächtnis 26 eine besonders einfache Handhabung erreichen, da das Mittel mit Formgedächtnis 26 beispielsweise durch Temperatureinwirkung aktiviert wird, das Flächensubstrat 4 mit der hierauf angeordneten elektrischen Schaltung 5 hierbei aber noch nicht in das Grundgehäuse 9 eingebracht ist. Durch diese Aktivierung beginnt das Mittel mit Formgedächtnis 26 sich raumgreifend zu verändern, also insbesondere das dargestellte Federelement 24 sich in Axialrichtung auszudehnen. Vor Erreichen einer Auflage des Federelements 24 auf der Abstützung 13 (also dem erwünschten Maß an Ausdehnung) wird das Flächensubstrat 4 mittels des Deckels 2 in das Grundgehäuse 9 eingebracht, indem einfach der Deckel 2 auf das Grundgehäuse 9 aufgestülpt wird. Das Ende 23 des Flächensubstrats 4 bewegt sich hierbei aufgrund der Geometrie des Grundgehäuses 9 und des Flächensubstrats 4, insbesondere der jeweiligen räumlichen Ausdehnung, zwangsläufig in den Klemmbereich 17 hinein, wo es von dem sich ausdehnenden Federelement 24 oberseitig beaufschlagt wird. Bei den beschriebenen Verklemmungen des Flächensubstrats 4 mittels Ausdehnmitteln 21 ergibt sich eine gute, insbesondere auch großflächige Abstützung des Flächensubstrats 4 an der Abstützung 13, die über eine größere Erstreckung des Grundgehäuses 9 ausgebildet sein kann, und hierbei immer noch wesentlich einfacher und billiger in der Herstellung ist als die aus dem Stand der Technik bekannten Schraubabstützungen oder Klipabstützungen. Gleichzeitig erfolgt die Kraftbeaufschlagung über das Ausdehnmittel 21 wesentlich großflächiger als dies bei Verschraubungen oder Verklipsungen der Fall wäre, wodurch unerwünschte, im Wesentlichen punktuelle mechanische Belastungen des Flächensubstrats 4 vermieden werden. Auf diese Weise ist eine einfache, sichere und leicht handhabbare Festlegung des Flächensubstrats 4 innerhalb des Einbaugehäuses 3 gewährleistet.

## Patentansprüche

1. Verfahren zum Festlegen eines eine elektrische Schaltung (5) aufweisenden Flächensubstrats in einer Einbauposition an einem Einbauelement (1), wobei ein Haltemittel (20) das Flächensubstrat (4) zur Festlegung beaufschlagt, und das Einbauelement (1) als Einbaugehäuse (3) ausgebildet ist, welches ein Grundgehäuse (9) und einen das Grundgehäuse (9) verschließenden Gehäusedeckel (2) aufweist, und wobei das Flächensubstrat (4) an dem Gehäusedeckel (2) befestigt ist und im Bereich des Grundgehäuses (9) auf der dem Gehäusedeckel (2) gegenüberliegenden Seite vom Haltemittel (20) beaufschlagt wird, **dadurch gekennzeichnet, dass** als Haltemittel (20) ein durch Temperaturbeaufschlagung aktivierbares Ausdehnmittel (21) verwendet wird und dass das Ausdehnmittel (21) ein Schaum, insbesondere Epoxy-Schaum (22) ist.

2. Verfahren nach Anspruch 1, **dadurch gekennzeichnet, dass** das Flächensubstrat (4) durch das Ausdehnmittel (21) klemmend beaufschlagt wird.

3. Verfahren nach einem der vorhergehenden Ansprüche, **dadurch gekennzeichnet, dass** die Aktivierung des Ausdehnmittels (21) auch durch Zeitablauf erfolgt.

4. Vorrichtung, insbesondere zur Durchführung des Verfahrens nach einem oder mehreren der vorhergehenden Ansprüche, mit mindestens einem eine elektrische Schaltung (5) aufweisenden Flächensubstrat (4), das in einer Einbauposition an einem Einbauelement (1) festgelegt ist, wobei ein Haltemittel (20) das Flächensubstrats (4) zur Festlegung beaufschlagt, und das Einbauelement (1) als Einbaugehäuse (3) ausgebildet ist, welches ein Grundgehäuse (9) und einen das Grundgehäuse (9) verschließenden Gehäusedeckel (2) aufweist, und wobei das Flächensubstrat (4) an dem Gehäusedeckel (2) befestigt ist und im Bereich des Grundgehäuses (9) auf der dem Gehäusedeckel (2) gegenüberliegenden Seite vom Haltemittel (20) beaufschlagt wird, **dadurch gekennzeichnet, dass** das Haltemittel (20) als durch Temperaturbeaufschlagung aktivierbares Ausdehnmittel (21) ausgebildet ist und das Ausdehnmittel (21) durch die Aktivierung mit einer Ausdehnung beginnt und dass als Ausdehnmittel (21) ein Schaum, insbesondere Epoxy-Schaum (22), vorgesehen ist.

5. Vorrichtung nach Anspruch 4, **dadurch gekennzeichnet, dass** das Einbaugehäuse (3) eine Abstützung (13) für mindestens eine Fläche (14) des Flächensubstrats (4) aufweist und dass das Haltemittel (20) die gegenüberliegende Fläche (14) des Flächensubstrats (4) klemmend beaufschlagt.

6. Vorrichtung nach einem der vorhergehenden Ansprüche 4-5, **dadurch gekennzeichnet, dass** das Grundgehäuse (9) eine Geometrie aufweist, bei der das Haltemittel (20) in einem nicht oder nur schwer zugänglichen Bereich angeordnet ist.

7. Vorrichtung nach einem der vorhergehenden Ansprüche 4-6, **dadurch gekennzeichnet, dass** das Grundgehäuse (9) topfförmig ausgebildet ist.

8. Vorrichtung nach Anspruch 5, **dadurch gekennzeichnet, dass** die Abstützung (13) auf der der Gehäuseöffnung (10) gegenüberliegenden Gehäuseseite (12) angeordnet ist.

9. Vorrichtung nach einem der vorhergehenden Ansprüche 4-9, **dadurch gekennzeichnet, dass** das Flächensubstrat (4) in einen Klemmbereich (17) eingeführt ist, der zwischen der Abstützung (13) und einer dieser beabstandet gegenüberliegenden, innerhalb des Grundgehäuses (9) angeordneten Gegenabstützung (18) gebildet wird.

## Claims

1. Method for immobilizing a sheet-like substrate, which has an electrical circuit (5), in an installation position on an installation element (1), wherein a holding means (20) acts on the sheet-like substrate (4) for immobilization purposes, and the installation element (1) is in the form of an installation housing (3) which has a main housing (9) and a housing cover (2) which closes the main housing (9), and wherein the sheet-like substrate (4) is fastened to the housing cover (2) and, in the region of the main housing (9), is acted on by the holding means (20) on that side which is opposite the housing cover (2), **characterized in that** an expansion agent (21) which can be activated by the application of temperature is used as holding means (20), and **in that** the expansion agent (21) is a foam, in particular epoxy foam (22).

2. Method according to Claim 1, **characterized in that** the sheet-like substrate (4) is acted on by the expansion agent (21) in a clamping manner.

3. Method according to either of the preceding claims, **characterized in that** the expansion agent (21) is also activated over the course of time.

4. Apparatus, in particular for carrying out the method according to one or more of the preceding claims, having at least one sheet-like substrate (4) which has an electrical circuit (5) and is immobilized in an installation position on an installation element (1), wherein a holding means (20) acts on the sheet-like substrate (4) for immobilization purposes, and the installation element (1) is in the form of an installation housing (3) which has a main housing (9) and a housing cover (2) which closes the main housing (9), and wherein the sheet-like substrate (4) is fastened to the housing cover (2) and, in the region of the main housing (9), is acted on by the holding means (20) on that side which is opposite the housing cover (2), **characterized in that** the holding means (20) is in the form of an expansion agent (21) which can be activated by the application of temperature, and the expansion agent (21) begins to expand due to the activation, and **in that** the expansion agent (21) provided is a foam, in particular epoxy foam (22).

5. Apparatus according to Claim 4, **characterized in that** the installation housing (3) has a support (13) for at least one surface (14) of the sheet-like substrate (4), and **in that** the holding means (20) acts on the opposite surface (14) of the sheet-like substrate (4) in a clamping manner.

6. Apparatus according to either of the preceding Claims 4 and 5, **characterized in that** the main housing (9) has a geometry with which the holding means (20) is arranged in a region which is not accessible or is accessible only with difficulty.

7. Apparatus according to one of the preceding Claims 4-6, **characterized in that** the main housing (9) is in the form of a pot.

8. Apparatus according to Claim 5, **characterized in that** the support (13) is arranged on that housing side (12) which is opposite the housing opening (10).

9. Apparatus according to one of the preceding Claims 4-9, **characterized in that** the sheet-like substrate (4) is inserted into a clamping region (17) which is formed between the support (13) and a mating support (18) which is situated opposite and at a distance from the said support and is arranged within the main housing (9).

## Revendications

1. Procédé pour caler un substrat plat muni d'un circuit électrique (5) à une position de montage sur un élément de montage (1), dans lequel un moyen de retenue (20) agit sur le substrat plat (4) de façon à le caler, et l'élément de montage (1) est réalisé sous la forme d'un logement de montage (3) qui comprend un logement de base (9) et un capot de logement (2) fermant le logement de base (9), et dans lequel le substrat plat (4) est fixé au capot de logement (2) et est sollicité par le moyen de retenue (20) dans la région du logement de base (9) sur la face opposée au capot de logement (2), **caractérisé en ce qu'**un moyen expansible (21) activable par application d'une température est utilisé en tant que moyen de retenue (20) et **en ce que** le moyen expansible (21) est une mousse, notamment une mousse époxy (22).

2. Procédé selon la revendication 1, **caractérisé en ce que** le substrat plat (4) est sollicité par le moyen expansible (21) par serrage.

3. Procédé selon l'une quelconque des revendications précédentes, **caractérisé en ce que** l'activation du moyen d'expansion (21) s'effectue également au cours du temps.

4. Dispositif, notamment destiné à mettre en oeuvre le procédé selon l'une ou plusieurs des revendications précédentes, comportant au moins un substrat plat (4) muni d'un circuit électrique (5), qui est calé à une position de montage sur un élément de montage (1), dans lequel un moyen de retenue (20) agit sur le substrat plat (4) de façon à le caler, et l'élément de montage (1) est réalisé sous la forme d'un logement de montage (3) qui comprend un logement de base (9) et un capot de logement (2) fermant le logement de base (9), et dans lequel le substrat plat (4) est fixé au capot de logement (2) et est sollicité par le moyen de retenue (20) dans la région du logement de base (9) sur la face opposée au capot de logement (2), **caractérisé en ce que** le moyen de retenue (20) est réalisé sous la forme d'un moyen expansible (21) activable par application d'une température et **en ce que** le moyen d'expansion (21) commence à subir une expansion du fait de l'activation et **en ce qu'**une mousse, notamment une mousse époxy (22), est prévue en tant que moyen d'expansion (21).

5. Dispositif selon la revendication 4, **caractérisé en ce que** le logement de montage (3) comprend un support (13) destiné à au moins une surface (14) du substrat plat (4) et **en ce que** le moyen de retenue (20) sollicite par serrage la surface opposée (14) du substrat plat (4).

6. Dispositif selon l'une quelconque des revendications 4-5 précédentes, **caractérisé en ce que** le logement de base (9) présente une géométrie telle que le moyen de retenue (20) est disposé dans une région non accessible ou seulement difficilement accessible.

7. Dispositif selon l'une quelconque des revendications 4-6 précédentes, **caractérisé en ce que** le logement de base (9) est réalisé sous la forme d'un pot.

8. Dispositif selon la revendication 5, **caractérisé en ce que** le support (13) est disposé sur la face (12) du logement qui est opposée à l'ouverture (10) du logement.

9. Dispositif selon l'une quelconque des revendications 4-9 précédentes, **caractérisé en ce que** le substrat plat (4) est introduit dans une zone de serrage (17) qui est formée entre le support (13) et un support complémentaire (18) opposé de manière espacée de celui-ci et disposé à l'intérieur du logement de base (9).
